# EUROPÄISCHE PATENTSCHRIFT

(11) **EP 2 735 025 B1**
(45) Veröffentlichungstag und Bekanntmachung des Hinweises auf die Patenterteilung: **24.04.2019**
(21) Anmeldenummer: 12737715.8
(22) Anmeldetag: 06.07.2012
(51) Int. Cl.: H01L 25/075, G02B 3/00, F21V 5/00

(54) **OPTOELEKTRONISCHES MODUL MIT LINSENSYSTEM**
OPTOELECTRONIC MODULE COMPRISING A LENS SYSTEM
MODULE OPTOÉLECTRONIQUE DOTÉ D'UN SYSTÈME DE LENTILLES

(30) Priorität: 18.07.2011 DE 102011107895
(43) Veröffentlichungstag der Anmeldung: 28.05.2014
(73) Patentinhaber: Heraeus Noblelight GmbH, 63450 Hanau (DE)
(72) Erfinder: SCHADT, Susanne, 63505 Langenselbold (DE); PEIL, Michael, 64853 Otzberg (DE); MAIWEG, Harald, 41352 Korschenbroich (DE); OSWALD, Florin, 60329 Frankfurt (DE); KRAUEL, Marcus, 22305 Hamburg (DE)
(74) Vertreter: Heraeus IP
(86) Internationale Anmeldenummer: PCT/EP2012/002838
(87) Internationale Veröffentlichungsnummer: WO 2013/010636

(56) Entgegenhaltungen:
- WO-A1-2010/108761
- JP-A- 7 211 943
- JP-A- 2007 027 325
- JP-A- 2007 080 526
- JP-A- 2007 207 956
- JP-A- 2010 192 347
- US-A1- 2007 030 675
- US-A1- 2011 007 513

## Beschreibung

Die Erfindung betrifft ein optoelektronisches Modul, eine optoelektronische Vorrichtung, ein Verfahren zur Herstellung eines optoelektronischen Moduls sowie eine Verwendung eines optoelektronischen Moduls. Derartige optoelektronische Module, optoelektronische Vorrichtungen, Verfahren und Verwendungen können auf verschiedene Weise in den Naturwissenschaften, der Technik, der Medizin und im täglichen Leben eingesetzt werden. Ein wichtiges Einsatzgebiet, auf welches die Erfindung jedoch nicht beschränkt ist, ist der Einsatz im Bereich der Prozesstechnik, beispielsweise zum Zweck einer Trocknung und/oder Härtung von Materialien und/oder Gegenständen oder auch zum Zweck einer fotochemischen Modifikation von Werkstücken. Alternativ oder zusätzlich können optoelektronische Module und optoelektronische Vorrichtungen der im Folgenden beschriebenen Art auch beispielsweise im Bereich der Beleuchtung eingesetzt werden, beispielsweise in der Verkehrstechnik und/oder in der Haustechnik.

Die Erfindung betrifft insbesondere optoelektronische Module, welche ganz oder teilweise als so genannte Chip-on-Board-Module ausgestaltet sind. Derartige Chip-on-Board-Module sind Module, welche ganz oder teilweise nach der sogenannten Chip-on-Board-Technologie (CoB) herstellbar sind. Bei der Chip-on-Board-Technologie werden ein oder mehrere ungehäuste Halbleiterbauelemente (Halbleiter-Chips) direkt auf einem Träger, beispielsweise einer Leiterplatte oder einer anderen Art von Schaltungsträger, montiert. Allgemein betrifft der Begriff eines Chip-on-Board-Moduls also eine elektronische Baugruppe, welche mindestens einen Träger sowie mindestens ein ungehäustes (nacktes), auf dem Träger montiertes Halbleiterbauelement beinhaltet. Derartige Chip-on-Board-Module werden beispielsweise als Leuchtkörper, als Hochleistungslampen (beispielsweise als Hochleistungs-UV-LED-Lampen), als Photovoltaik-Module, als Sensoren oder in anderer Weise verwendet. Insbesondere handelt es sich bei den vorgeschlagenen optoelektronischen Modulen um optoelektronische Chip-on-Board-Module mit einer Mehrzahl von optoelektronischen Komponenten. Bei den dabei verwendeten optoelektronischen Komponenten kann es sich im Rahmen der vorliegenden Erfindung beispielsweise, jedoch nicht ausschließlich, um Leuchtdioden (LEDs) und/oder Fotodioden, insbesondere in Form von Chips oder anderen Bauteilen, handeln, die im Chip-on-Board-Modul auf einem flächigen Träger, insbesondere einem Metall-, Keramik- oder Siliciumsubstrat, einer Metallkern-oder FR4-Leiterplatte, einem Glasträger, einem Kunststoffträger, einem Metallmatrixverbundmaterial oder ähnlichen Trägern angeordnet sind. Diese Chip-on-Board-Module müssen vor mechanischen Schäden und Korrosion geschützt werden. Hierzu werden möglichst kompakte und leichte Lösungen gesucht.

Da ein Schutz in der Form von Gehäusen auf Chip-on-Board-Modulen in der Regel kostenaufwändig und technologisch aufwändig ist, ist aus dem Stand der Technik als praktikable Alternative zum Schutz von derartigen Chip-on-Board-Modulen ein flächiger Verguss aller oder mehrerer Komponenten mit einem kunststoffbasierten Vergussmaterial bekannt. Zusammen mit weiteren funktionalen Komponenten, wie etwa Leiterbahnen und Kontaktierungselementen, können die optoelektronischen Komponenten in Chip-on-Board-Modulen zusammen mit einem flächigen Träger durch Beschichtungen vor mechanischen Schäden und Korrosion geschützt werden.

Weiterhin spielt für viele Anwendungen eine Richtcharakteristik der optoelektronischen Module eine entscheidende Rolle. Eine Richtcharakteristik beschreibt allgemein für optoelektronische Komponenten eine Winkelabhängigkeit der Stärke empfangener oder gesendeter Wellen, welche meist bezogen ist auf eine Empfindlichkeit und/oder Intensität in einer Hauptrichtung, also entlang einer optischen Achse der optoelektronischen Komponenten. Insbesondere spielt bei optoelektronischen Modulen, welche eine oder mehrere Leuchtdioden als optoelektronische Komponenten umfassen, in der Regel eine Bestrahlungsstärke und/oder eine Abstrahlcharakteristik des optoelektronischen Moduls eine entscheidende Rolle. Diese Abstrahlcharakteristik als Sonderform der Richtcharakteristik beschreibt in diesem Fall die Winkelabhängigkeit des elektromagnetischen Feldes und/oder der Intensität der emittierten elektromagnetischen Wellen, insbesondere in Form von infrarotem, ultraviolettem oder sichtbarem Licht. Chip-on-Board-Module bieten den Vorteil, dass Leuchtdioden in hoher Packungsdichte auf den Träger aufgebracht werden können, was die Bestrahlungsstärke erhöht. Dennoch wird in vielen Fällen eine zusätzliche Optik verwendet, um die Abstrahlcharakteristik der optoelektronischen Module zu beeinflussen. Beispielsweise kann es sich bei dieser Optik, sowohl für lichtemittierende optoelektronische Module als auch für fotosensitive optoelektronische Module, um Linsensysteme mit einer oder mehreren Linsen, insbesondere um sogenannte Mikrolinsensysteme, handeln. Die Linsensysteme, insbesondere die Mikrolinsensystem, können beispielsweise ein oder mehrere strahlformende Elemente umfassen, deren laterale Ausdehnung, beispielsweise deren Ausdehnung in einer Ebene des Trägers, vom sub-Millimeter-Bereich bis in den DezimeterBereich oder sogar bis in den Meter-Bereich reichen kann. Die Mikrolinsensysteme können beispielsweise derart ausgestaltet sein, dass diese optisch wirksame Bereiche Strukturen im sub-Millimeter-Bereich aufweisen, beispielsweise Strukturen mit beugender, streuender, sammelnder, kollimierender oder diffundierender Wirkung.
Aufgrund der in der Regel notwendigen geringen Abstände zwischen den optoelektronischen Komponenten, insbesondere aufgrund des geringen, typischerweise bei Chip-on-Board-Modulen verwendeten Pitch (Abstand Mitte-zu-Mitte zwischen benachbarten optoelektronischen Komponenten) sind nur wenige Verfahren bekannt, in denen strahlformende Mikrolinsen über den einzelnen optoelektronischen Komponenten, beispielsweise den einzelnen Leuchtdioden eines Leuchtdioden-Arrays, realisiert werden können, beispielsweise durch ein entsprechendes Vergussmaterial.

So beschreibt beispielsweise die nachveröffentlichte DE 10 2010 044 470 aus dem Hause der Anmelderin der vorliegenden Anmeldung ein Verfahren zur Beschichtung eines optoelektronischen Chip-on-Board-Moduls, welches einen flächigen Träger umfasst, der mit einer oder mehreren optoelektronischen Komponenten bestückt ist. Dabei wird eine transparente, UV- und temperaturbeständige Beschichtung aus einem oder mehreren Silikonen verwendet. Bei dem Verfahren wird der zu beschichtende Träger auf eine erste Temperatur vorgewärmt. Weiterhin wird ein Damm aufgebracht, welcher eine zu beschichtende Fläche oder Teilfläche des Trägers einschließt. Dieser Damm ist ganz oder teilweise zusammengesetzt aus einem ersten, thermisch aushärtenden, hochreaktiven Silikon, das bei einer ersten Temperatur aushärtet. Dieses erste Silikon wird auf den vorgewärmten Träger aufgebracht. Weiterhin wird die von dem Damm eingeschlossene Fläche oder Teilfläche des Trägers mit einem flüssigen zweiten Silikon aufgefüllt, und das zweite Silikon wird ausgehärtet. Dabei können, insbesondere mittels des ersten Silikons, auch schnell aushärtende Linsen auf einzelne Komponenten des Trägers aufgetragen werden. Auf diese Weise sind auch Mikrolinsensysteme formbar.

Weiterhin ist aus der ebenfalls nachveröffentlichten und aus dem Hause der Anmelderin der vorliegenden Anmeldung stammenden DE 10 2010 044 471 ein Beschichtungsverfahren für ein optoelektronisches Chip-on-Board-Modul bekannt. Wiederum umfasst das optoelektronische Chip-on-Board-Modul einen flächigen Träger, der mit einem oder mehreren optoelektronischen Komponenten bestückt ist und eine transparente, UV- und temperaturbeständige Beschichtung aus einem Silikon aufweist. Das Verfahren umfasst einen Verfahrensschritt eines Vergießens eines flüssigen Silikons in eine nach oben offene Form, die Außenmaße aufweist, die den Außenmaßen des Trägers entsprechen oder diese übersteigen. Weiterhin wird der Träger in die Form eingeführt, wobei die optoelektronische Komponente oder die optoelektronischen Komponenten vollständig in das Silikon eintauchen. In einem weiteren Verfahrensschritt wird das Silikon ausgehärtet und vernetzt, mit den optoelektronischen Komponenten und dem Träger. Weiterhin wird der Träger mit der Beschichtung aus dem ausgehärteten Silikon aus der Form entnommen.

Weiterhin ist aus US 7,819,550 B2 ein LED-Array bekannt, welches ein Linsen-Array zum Sammeln divergenten Lichtes von jeder LED umfasst. Die Linsen umfassen jeweils einen ebenen Abschnitt und zwei gekrümmte Abschnitte. Oberhalb der Leuchtdioden sind die Linsen nicht gekrümmt.

Aus US 2007/0045761 A1 ist ein Verfahren zur Herstellung einer Weißlicht-LED bekannt. Dabei wird eine LED verwendet, welche blaues Licht emittiert, und es werden Phosphore verwendet, welche das Licht konvertieren. Unter Anderem wird dabei auch die Ausformung von Optiken über den Leuchtdioden beschrieben, welche mittels eines Gießprozesses, der atmosphärisch abgedichtet ist, erzeugt werden.

Aus US 2010/0065983 A1 ist weiterhin ein Verfahren zur Verkapselung von Leuchtdioden mittels eines Kompressions-Gießverfahrens bekannt. Dabei wird zur Abdichtung während des Gießprozesses ein Band verwendet.

Die Dokumente JP7211943 A, WO2010/108761 A1, US2007/030675 A1, JP2010192347 A, JP2007080526 A, US2011/007513 A1, JP2007207956 A und JP2007027325 A betreffen eindimensionale oder zweidimensionale Anordnungen von Leuchtdioden mit einem Linsensystem.

Trotz der durch die oben beschriebenen Verfahren erzielten Verbesserungen bekannter optoelektronischer Module besteht nach wie vor ein Bedarf an optoelektronischen Modulen mit verbesserter Richtcharakteristik, insbesondere ein Bedarf an optoelektronischen Modulen mit hoher Bestrahlungsstärke für bestimmte Anwendungen. Insbesondere besteht ein Bedarf nach effizienten und aneinander anreihbaren Lichtquellen, deren Beleuchtungsprofil in einem einstellbaren Abstand eine hohe Bestrahlungsstärke besitzen kann, wobei gleichzeitig hohe Homogenitätsanforderungen erfüllt und im Randbereich ein ausreichend steiler Abfall zu verzeichnen ist. Insbesondere in der industriellen Fertigung in der Druckindustrie bei Lithographieanwendungen werden derartige optoelektronische Module, insbesondere Leuchtdiodenmodule, benötigt, um ein gleichmäßiges und qualitativ hochwertiges Trocknungsbild von Druckfarben und Tinten zu erzielen. Hohe Bestrahlungsstärken, beispielsweise in der Regel Bestrahlungsstärken von mehr als 100 mW/cm², typischerweise 1-20 W/cm², bis hin wenigen 100 W/cm², sind in der Regel notwendig, um hohe Prozessgeschwindigkeiten bei möglichst kompakten und energieeffizienten Lichtquellen zu erreichen.

Es ist daher eine Aufgabe der vorliegenden Erfindung, ein optoelektronisches Modul bereitzustelen, welches die Nachteile bekannter Verfahren zumindest weitgehend vermeidet und welches die vorgenannten Anforderungen zumindest weitgehend erfüllt. Insbesondere soll ein optoelektronisches Modul bereitgestellt werden, welches, in einer Ausgestaltung als lichtemittierendes Modul, eine hohe Effizienz und Bestrahlungsstärke aufweist, welches als anreihbare Lichtquelle einsetzbar ist und welches ein Beleuchtungsprofil mit hoher Homogenität und ausreichend steilem Abfall in einem Randbereich aufweist.

Diese Aufgabe wird gelöst durch ein optoelektronisches Modul, eine optoelektronische Vorrichtung, ein Verfahren und eine Verwendung mit den Merkmalen der unabhängigen Patentansprüche. Vorteilhafte Weiterbildungen der Erfindung, welche einzeln oder in Kombination realisierbar sind, sind in den abhängigen Ansprüchen dargestellt.

In einem ersten Aspekt der vorliegenden Erfindung wird ein optoelektronisches Modul vorgeschlagen. Unter einem optoelektronischen Modul ist allgemein eine Baugruppe zu verstehen, welche als Einheit gehandhabt werden kann und welche mindestens eine optoelektronische Komponente, also beispielsweise eine lichtemittierende elektronische Komponente und/oder eine lichtsensitive elektronische Komponente, aufweist. Das optoelektronische Modul kann insbesondere als optoelektronisches Chip-on-Board-Modul gemäß der oben genannten Definition ausgestaltet sein.

Das optoelektronische Modul umfasst einen Träger, welcher flächig ausgestaltet ist. Unter einem Träger ist allgemein im Rahmen der vorliegenden Erfindung ein Element zu verstehen, welches eingerichtet ist, um eine oder mehrere elektronische, insbesondere eine oder mehrere optoelektronische, Komponenten aufzunehmen. Insbesondere kann der Träger gemäß der oben, bezüglich des Standes der Technik beschriebenen Art ausgestaltet sein und kann einen oder mehrere Schaltungsträger umfassen, insbesondere gemäß der genannten Art. Unter einer flächigen Ausgestaltung ist eine Ausgestaltung zu verstehen, bei welcher mindestens eine mit der optoelektronischen Komponente, insbesondere einem ungehäusten Chip, beschlagbare Oberfläche vorgesehen ist, beispielsweise eine ebene oder leicht gekrümmte Oberfläche, auf welche ein oder mehrere optoelektronische Komponenten, insbesondere ein oder mehrere optoelektronische Chips ohne Gehäuse, aufgebracht werden können. Beispielsweise kann der flächig ausgestaltete Träger ganz oder teilweise eben ausgestaltet sein, beispielsweise als Leiterplatte.

Weiterhin umfasst das optoelektronische Modul eine Mehrzahl von auf dem Träger angeordneten optoelektronischen Komponenten. Diese optoelektronischen Komponenten können insbesondere in Chip-on-Board-Technik auf dem Träger angeordnet sein. Unter optoelektronischen Komponenten sind, wie oben beschrieben, Bauelemente zu verstehen, welche mindestens eine optoelektronische Funktion erfüllen, beispielsweise eine lichtemittierende und/oder eine lichtsensitive Funktion. Insbesondere können die optoelektronischen Komponenten ausgewählt sein aus der Gruppe bestehend aus Leuchtdioden und Fotodioden. Die optoelektronischen Komponenten können insbesondere einen oder mehrere ungehäuste Chips umfassen. Dementsprechend kann die Mehrzahl von optoelektronischen Komponenten insbesondere ein Array optoelektronischer Komponenten umfassen, also eine Anordnung, bei welcher eine Mehrzahl von optoelektronischen Komponenten in mehreren Reihen auf den Träger aufgebracht sind. Das Array kann beispielsweise eine rechteckige Matrix mit einer Mehrzahl von Zeilen und Spalten umfassen. Unter einer Zeile und/oder einer Spalte ist dabei eine lineare Anordnung von mindestens zwei, vorzugsweise mindestens drei, vier oder mehr optoelektronischen Komponenten zu verstehen. Die Mehrzahl optoelektronischer Komponenten kann also vorzugsweise eine rechteckige Matrix von Leuchtdioden und/oder Fotodioden aufweisen. Auch andere Ausgestaltungen sind jedoch grundsätzlich möglich, beispielsweise Ausgestaltungen, bei welchen die Mehrzahl von optoelektronischen Komponenten unregelmäßig auf dem Träger angeordnet ist und/oder in einer nicht-rechteckigen Matrix auf dem Träger angeordnet ist.

Das optoelektronische Modul umfasst weiterhin ein Linsensystem, insbesondere ein Mikrolinsensystem, mit einer Mehrzahl von Linsen, insbesondere Mikrolinsen. Unter einer Linse ist dabei allgemein ein optisches Element zu verstehen, welches eine Strahlformung elektromagnetischer Strahlen durchführen kann, bei welcher die elektromagnetischen Strahlen mindestens einmal gebrochen werden. Linsen, beispielsweise Mikrolinsen, können dabei laterale Abmessungen vom sub-Millimeter-Bereich bis in den Meter-Bereich aufweisen. Beispielsweise können Lampensysteme für Industrieanwendungen laterale Ausdehnungen, beispielsweise Längen, von bis zu 3 m oder mehr aufweisen. Insbesondere können die Linsen sammelnde und/oder streuende Eigenschaften aufweisen. Unter einem Linsensystem, insbesondere einem Mikrolinsensystem, ist eine Mehrzahl von Linsen, insbesondere Mikrolinsen, zu verstehen, welche vorzugsweise nebeneinander angeordnet sind, beispielsweise in einer Ebene parallel zu einer Ebene des flächig ausgestalteten Trägers. Das Linsensystem kann beispielsweise ein Array von Linsen umfassen, wobei mehrere Linsen in einer oder mehreren Zeilen und/oder einer oder mehreren Spalten angeordnet sind. Beispielsweise kann das Linsenarray wiederum ein rechteckiges Array aufweisen. Wie unten noch näher ausgeführt wird, kann beispielsweise jeweils eine Linse genau einer optoelektronischen Komponente oder einer Gruppe mehrerer optoelektronischer Komponenten zugeordnet sein, sodass das Linsensystem beispielsweise in einem Array angeordnet sein kann, welches dem Array der optoelektronischen Komponenten entsprechen kann. Insbesondere kann das Linsensystem ganz oder teilweise aus einem durchgehend ausgestalteten optisch transparenten Material hergestellt sein, welches mehrere oder alle der Linsen des Linsensystems bildet. Dieses optisch transparente Material, beispielsweise ein Kunststoffmaterial, kann insbesondere direkt auf die optoelektronischen Komponenten aufgebracht sein, beispielsweise in einem Gießverfahren. So kann das Linsensystem allgemein ein optisch transparentes Material umfassen, welches in Kontakt mit den optoelektronischen Komponenten steht und welches die mehreren Linsen oder zumindest mehrere der Linsen des Linsensystems bildet.

Das Linsensystem weist mindestens zwei Linsen, beispielsweise mindestens zwei Mikrolinsen, mit unterschiedlicher Richtcharakteristik auf. Wie oben ausgeführt, ist unter einer Richtcharakteristik dabei allgemein im Rahmen der vorliegenden Erfindung eine Winkelabhängigkeit empfangener oder gesendeter elektromagnetischer Wellen, insbesondere Licht im sichtbaren und/oder infraroten und/oder ultravioletten Spektralbereich, zu verstehen. Diese Winkelabhängigkeit kann sich beispielsweise auf das elektromagnetische Feld der elektromagnetischen Wellen beziehen. Alternativ oder zusätzlich kann sich die Winkelabhängigkeit auch beispielsweise auf eine Intensität und/oder eine Energiedichte und/oder eine andere, die Stärke der elektromagnetischen Wellen charakterisierende physikalische Größe beziehen. Die Richtcharakteristik kann beispielsweise angegeben sein in Bezug auf eine Stärke in einer Hauptrichtung, welche beispielsweise parallel zu einer optischen Achse der optoelektronischen Komponente ist, beispielsweise eine Achse, welche eine sensitive und/oder emittierende aktive Fläche der optoelektronischen Komponente senkrecht zentrisch durchstößt. Insbesondere kann die Richtcharakteristik eine Abstrahlcharakteristik umfassen, wenn das optoelektronische Modul eine oder mehrere optoelektronische Komponenten in Form lichtemittierender Komponenten, beispielsweise Leuchtdioden, umfasst. Die Abstrahlcharakteristik kann beispielsweise mittels eines entsprechenden Sensors gemessen werden, welcher in variablem Winkel in einem vorgegebenen Abstand vor der optoelektronischen Komponente angeordnet ist, wobei kontinuierlich oder diskontinuierlich Messungen einer Stärke der Emission, beispielsweise Messungen einer Intensität, bei unterschiedlichen Winkeln vorgenommen werden. Auf diese Weise lassen sich, beispielsweise mittels entsprechender Polardiagramme der Messungen, Richtcharakteristiken erfassen. Derartige Messverfahren sind dem Fachmann aus dem Bereich der Beleuchtungstechnik bekannt. Grundsätzlich ist dabei die präzise Ausgestaltung des verwendeten Verfahrens für die vorliegende Erfindung nicht von Bedeutung, da lediglich ein Vergleich der Richtcharakteristiken der Linsen erfolgt.

Unter einer Richtcharakteristik einer Linse kann insbesondere eine Richtcharakteristik einer Linse in Zusammenwirkung mit einer, der Linse zugeordneten optoelektronischen Komponente, beispielsweise einer Leuchtdiode, verstanden werden. Insbesondere können die Linsen, wie oben beschrieben, jeweils einer optoelektronischen Komponente der Mehrzahl von optoelektronischen Komponenten zugeordnet werden, sodass beispielsweise über jeder optoelektronischen Komponente genau eine Linse des Linsensystems angeordnet ist. Unter einer Richtcharakteristik der Linse ist dementsprechend dann die Richtcharakteristik der Gruppe zu verstehen, die sich aus der optoelektronischen Komponente sowie der darüber angeordneten Linse zusammensetzt.

Die Richtcharakteristiken der mindestens zwei Linsen können sich beispielsweise hinsichtlich eines Öffnungswinkels unterscheiden, beispielsweise hinsichtlich eines Abstrahlwinkels. Beispielsweise kann unter einem Abstrahlwinkel ein Winkel verstanden werden, welcher von den seitlichen Punkten mit halber Maximal-Lichtstärke eingeschlossen wird. Auch andere Charakteristika der Richtcharakteristik können jedoch für den Vergleich der Richtcharakteristiken herangezogen werden.

Die mindestens zwei Linsen, deren Richtcharakteristiken sich voneinander unterscheiden, sind in einem Inneren des Linsensystems, beispielsweise des Linsenarrays, und an einem Rand des Linsensystems, beispielsweise des Linsenarrays, angeordnet. So kann beispielsweise das Linsensystem ein Linsenarray in Form einer zweidimensionalen Matrix von Linsen umfassen. Dabei können beispielsweise an einem Rand des Linsenarrays angeordnete Linsen eine andere Richtcharakteristik aufweisen als im Inneren der Linsenarrays angeordnete Linsen. Beispielsweise kann dieser Rand bei einer linearen Matrix jeweils aus den äußersten Linsen bestehen. Bei einer zweidimensionalen Matrix kann der Rand eine Linie oder einen Rahmen von Linsen umfassen, welche am Rand des Linsensystems angeordnet sind. Diese Ränder können sich von mindestens einer Linse, welche im Inneren des Linsensystems, also abseits des Randes, angeordnet ist, hinsichtlich Ihrer Richtcharakteristiken unterscheiden. Dabei können die Linsen des Linsensystems derart ausgestaltet sein, dass mindestens zwei Gruppen von Linsen vorgesehen sind, wobei die Linsen mindestens einer ersten Gruppe eine erste Richtcharakteristik aufweisen und wobei die Linsen der mindestens einen zweiten Gruppe mindestens eine zweite Richtcharakteristik aufweisen, wobei sich die erste Richtcharakteristik und die zweite Richtcharakteristik unterscheiden. Dabei kann das Linsensystem eine stufenweise Veränderung der Richtcharakteristiken aufweisen, sodass sich beispielsweise die Richtcharakteristiken von einem Inneren des Linsensystems hin zu einem Rand des Linsensystems kontinuierlich oder diskontinuierlich verändern. Dabei können zwei oder mehr Stufen der Veränderung vorgesehen sein.

Die optoelektronischen Komponenten können, wie oben ausgeführt, in einem zweidimensionalen Array, also in einer zweidimensionalen Matrix, auf dem Träger angeordnet sein. Insbesondere kann dieses Array eine zweidimensionale Matrix umfassen, wobei bei einer zweidimensionalen Matrix in zwei Dimensionen mindestens jeweils zwei optoelektronische Komponenten angeordnet sind. Insbesondere kann das zweidimensionale Array eine Anzahl von mindestens 4, mindestens 8, mindestens 10, mindestens 50 oder sogar mindestens 100 optoelektronischen Komponenten umfassen. Dabei ist eine gerade Anzahl optoelektronischer Komponenten oder auch eine ungerade Anzahl optoelektronischer Komponenten denkbar, da beispielsweise auch von rechteckigen Gitteranordnungen abweichende Anordnungen in einem Array realisierbar sind, beispielsweise hexagonale Anordnungen der optoelektronischen Komponenten im Array, beispielsweise hexagonale LED-Arrays.

Die optoelektronischen Komponenten können, wie oben ausgeführt, insbesondere ausgewählt sein aus der Gruppe bestehend aus Leuchtdioden, insbesondere Oberflächen-emittierenden Leuchtdioden, und Fotodioden.

Die mindestens zwei Linsen mit unterschiedlicher Richtcharakteristik können insbesondere Linsen mit unterschiedlicher Oberflächenkrümmung umfassen. Unter einer Oberflächenkrümmung ist dabei allgemein eine Gestaltung der Oberfläche in einer oder mehreren Schnittebenen durch die Linse zu verstehen, beispielsweise eine Schnittebene, welche durch eine optische Achse der optoelektronischen Komponente und/oder der Linse verläuft, welche auch als Hauptrichtung bezeichnet wird. Die Linsen können rotationssymmetrisch um diese optische Achse ausgestaltet sein oder können auch asymmetrisch ausgestaltet sein. Eine konvexe Krümmung kann beispielsweise einen Bereich mit einer Sammelwirkung beschreiben, und eine konkave Krümmung kann beispielsweise einen Bereich mit einer Streuwirkung beschreiben.

Zusätzlich zu Linsen mit unterschiedlicher Oberflächenkrümmung umfassen die mindestens zwei Linsen mit unterschiedlicher Richtcharakteristik auch Linsen mit unterschiedlicher Höhe. Unter einer Höhe ist dabei allgemein ein Abstand zwischen einer äußersten Oberfläche der Linse und einer aktiven Fläche der elektrischen Komponente zu verstehen, welche der Linse zugeordnet ist. Beispielsweise kann dieser Abstand entlang einer optischen Achse senkrecht zu dem Träger und/oder senkrecht zu dieser aktiven Fläche gemessen werden.

Alternativ oder zusätzlich zu den vorangehend beschriebenen Ausgestaltungen können die mindestens zwei Linsen mit unterschiedlicher Richtcharakteristik auch Linsen mit unterschiedlicher Grundfläche umfassen. Unter einer Grundfläche ist dabei die Gestalt und/oder das Ausmaß der Linse in einer Schnittebene zu verstehen, welche in der Ebene einer aktiven Fläche der optoelektronischen Komponente liegt, die der Linse zugeordnet ist. Diese Ebene kann mit einer Ebene des Trägers zusammenfallen oder kann auch versetzt zu dieser Ebene des Trägers angeordnet sein.

Alternativ oder zusätzlich zu einer oder mehreren der vorangehend genannten Möglichkeiten können die mindestens zwei Linsen mit unterschiedlicher Richtcharakteristik auch Linsen umfassen, bei welchen jeweils eine optische Achse der Linse in unterschiedlicher Weise zu jeweils einer optischen Achse der optoelektronischen Komponente ausgerichtet ist. So kann beispielsweise, wie oben ausgeführt, jeweils eine Linse genau eine optoelektronische Komponente oder auch eine Mehrzahl optoelektronischer Komponenten zugeordnet sein. Die Linse kann eine optische Achse aufweisen, und die zugeordnete optoelektronische Komponente kann ebenfalls eine optische Achse aufweisen. Dabei kann ein radialsymmetrischer Aufbau verwendet werden, bei welcher die optischen Achsen der Linse und der zugeordneten optoelektronischen Komponente zusammenfallen. Auch eine andere Ausrichtung ist jedoch grundsätzlich möglich, beispielsweise eine Ausrichtung, bei welcher die optischen Achsen der Linse und der zugeordneten optoelektronischen Komponente zueinander parallel versetzt sind. Alternativ oder zusätzlich können die optische Achse der Linse und die optische Achse der optoelektronischen Komponente auch zueinander verkippt ausgerichtet sein. Auch auf diese Weisen lässt sich grundsätzlich die Abstrahlcharakteristik der aus der Linse und der zugeordneten optoelektronischen Komponente bestehenden Gruppe verändern. Auf diese Weise lassen sich ebenfalls Linsen herstellen, welche unterschiedliche Richtcharakteristiken aufweisen. Besonders bevorzugt ist es, wenn das Linsensystem mindestens eine Linse umfasst, bei welcher eine optische Achse der Linse zu einer optischen Achse einer der Linse zugeordneten optoelektronischen Komponente versetzt angeordnet ist, beispielsweise parallelversetzt.

Wie oben ausgeführt, kann das Linsensystem insbesondere derart ausgestaltet sein, dass der optoelektronischen Komponente genau eine Linse zugeordnet ist. Insbesondere kann die Mehrzahl optoelektronischer Komponenten eine Matrix optoelektronischer Komponenten umfassen, wobei die Matrix zweidimensional ausgestaltet ist. Entsprechend kann das Linsensystem eine Matrix von Linsen umfassen, welche zweidimensional ausgestaltet ist. Dabei können die Matrizes der Linsen und der optoelektronischen Komponenten einander entsprechen, sodass genau einem Element der Matrix der Linsen ein Element der Matrix der optoelektronischen Komponenten zugeordnet ist. Diese Zuordnung kann beispielsweise derart erfolgen, dass die Linsen über den zugeordneten optoelektronischen Komponenten angeordnet sind, sodass von den optoelektronischen Komponenten emittiertes Licht die zugeordnete Linse passiert und/oder das Licht zunächst die Linse passiert, um dann von der der jeweiligen Linse zugeordneten optoelektronischen Komponente aufgenommen zu werden. Wie oben ausgeführt, ist in diesem Fall unter einem Linsensystem mit mindestens zwei Linsen mit unterschiedlicher Richtcharakteristik insbesondere zu verstehen, dass das optoelektronische Modul mindestens zwei Gruppen, bestehend jeweils aus mindestens einer Linse und mindestens einer zugeordneten optoelektronischen Komponente, umfasst, deren Richtcharakteristiken voneinander unterschiedlich sind, beispielsweise hinsichtlich eines Öffnungswinkels und/oder Abstrahlwinkels der jeweiligen Richtcharakteristiken.

Das Linsensystem kann insgesamt eine Gesamt-Richtcharakteristik aufweisen, die sich aus den Richtcharakteristiken sämtlicher Linsen zusammensetzt. Diese Richtcharakteristik kann beispielsweise erfasst werden, wenn alle optoelektronischen Komponenten des optoelektronischen Moduls gleichzeitig aktiv sind und als Einheit wirken. Die Gesamt-Richtcharakteristik kann insbesondere mit einer hohen Homogenität ausgestaltet sein, beispielsweise mit einer höheren Homogenität als die Richtcharakteristik eines identischen optoelektronischen Moduls, welches kein Linsensystem aufweist. Diese Homogenität kann auf verschiedene Weisen erfasst werden. Beispielsweise kann ein zentraler Bereich der optoelektronischen Komponenten, beispielsweise der eindimensionalen oder zweidimensionalen Matrix der optoelektronischen Komponenten definiert werden, welcher in mindestens einer Dimension auf dem Träger mindestens 50% des Linsensystems und/oder der Matrix optoelektronischer Komponenten umfasst. Dabei kann das optoelektronische Modul mittels der zusammengesetzten Gesamt-Richtcharakteristik derart ausgestaltet werden, dass die Richtcharakteristik innerhalb dieses zentralen Bereichs eine Abweichung von nicht mehr als 20% von einem Mittelwert der Gesamt-Richtcharakteristik innerhalb des zentralen Bereichs aufweist. Diese Abweichung kann beispielsweise bezogen werden auf eine elektrische Feldstärke eingestrahlter und/oder abgestrahlter elektromagnetischer Wellen. Alternativ oder zusätzlich kann diese Homogenitätsdefinition auch beispielsweise bezogen werden auf eine Intensität der eingestrahlten und/oder abgestrahlten elektromagnetischen Wellen.

Die Homogenität der Gesamt-Richtcharakteristik kann auf verschiedene Weisen erfindungsgemäß verbessert werden im Vergleich zu herkömmlichen optoelektronischen Modulen. So kann beispielsweise mindestens eine Linse an einem Rand des Linsensystems vorgesehen sein, welche einen kleineren Öffnungswinkel hinsichtlich ihrer Richtcharakteristik aufweist als mindestens eine in einem Inneren des Linsensystems angeordnete Linse. Insbesondere kann dieser Öffnungswinkel 80% oder weniger des Öffnungswinkels der im Inneren des Linsensystems angeordneten mindestens einen Linse betragen, also auf das 0,8-fache oder weniger reduziert sein im Vergleich zu dem Öffnungswinkel der im Inneren des Linsensystems angeordneten mindestens einen Linse. Besonders bevorzugt kann dieser Öffnungswinkel 60% oder weniger des Öffnungswinkels der im Inneren des Linsensystems angeordneten mindestens einen Linse betragen, also auf das 0,6-fache oder weniger reduziert sein im Vergleich zu dem Öffnungswinkel der im Inneren des Linsensystems angeordneten mindestens einen Linse. Diese Bedingung kann sich auf eine einzige, an einem Rand des Linsensystems angeordnete Linse oder auf mehrere am Rand des Linsensystems angeordnete Linsen beziehen. Wie oben ausgeführt, kann auch eine stufenweise oder stufenlose Veränderung des Öffnungswinkels der Richtcharakteristik erfolgen. Bei einem optoelektronischen Modul mit einer oder mehreren optoelektronischen Komponenten in Form von Leuchtdioden kann sich der Öffnungswinkel beispielsweise auf einen Abstrahlwinkel beziehen.

Bei einer LED kann beispielsweise der Öffnungswinkel oder Abstrahlwinkel als der Winkel definiert sein, bei dem die Strahlungsdichte noch 50% der maximalen Strahlungsdichte bei einem Winkel von 0° zur optischen Achse beträgt. Eine LED ist typischerweise als Lambertscher Strahler ausgestaltet. Ein Lambertscher Strahler weist allgemein typischerweise einen Abstrahlwinkel von ca. 60° auf. Der oben genannte Faktor von mindestens 0,8 führt in diesem Fall mit 0,8 x 60° = 48° bereits zu einer deutlichen Einschränkung des Öffnungswinkels, der hier beispielsweise auch als Kollimationswinkel bezeichnet werden kann. Für LEDs sind bei starker Kollimation typischerweise noch Abstrahlwinkel von bis hinunter zu 5° denkbar, wobei ein typischerweise sinnvoller Bereich für kollimierende Anwendungen im Bereich von 10°-30° liegt. Für hohe Auskopplungseffizienzen im Inneren der Arrays sind Winkel von 30° bis 60° oder mehr typisch.

Alternativ oder zusätzlich kann auch mindestens eine Linse an einem Rand des Linsensystems vorgesehen sein, wobei diese Linse einen größeren Öffnungswinkel ihrer Richtcharakteristik aufweist als mindestens eine in einem Inneren des Linsensystems angeordnete Linse. Beispielsweise kann der Öffnungswinkel dieser Linse 120% des Öffnungswinkels der inneren Linse betragen oder mehr, also auf einen Faktor 1,2 oder mehr erhöht sein oder mehr. Besonders bevorzugt kann der Öffnungswinkel dieser Linse 140% des Öffnungswinkels der inneren Linse betragen oder mehr, also auf einen Faktor 1,4 erhöht sein oder mehr. Auch andere Ausgestaltungen sind jedoch grundsätzlich möglich. Wiederum kann sich diese Bedingung auf eine oder mehrere an einem Rand des Linsensystems angeordnete Linsen beziehen, wobei auch grundsätzlich beispielsweise eine stufenlose und/oder stufenweise Veränderung des Öffnungswinkels möglich ist.

Die Linsen können grundsätzlich eine oder mehrere gekrümmte Oberflächen aufweisen. Insbesondere weist mindestens eine Linse des Linsensystems eine Oberflächenkrümmung mit mindestens einem konvex gekrümmten Bereich und mindestens einem konkav gekrümmten Bereich auf. Der konkav gekrümmte Bereich kann beispielsweise ringförmig von dem konvex gekrümmten Bereich umgeben sein. Wie oben ausgeführt, ist dabei unter einem konvex gekrümmten Bereich ein Bereich mit einer Sammelwirkung hinsichtlich der optischen Achse der Linse zu verstehen, wohingegen unter einem konkav gekrümmten Bereich ein Bereich zu verstehen ist, der eine Streuwirkung hinsichtlich Licht aufweist, dass die Linse verlässt. Die konvex gekrümmten und konkav gekrümmten Bereiche können insbesondere auf einer dem Träger abgewandten Seite des Linsensystems angeordnet sein, insbesondere wenn die optoelektronischen Komponenten in unmittelbaren Kontakt mit einem Material des Linsensystems stehen oder beispielsweise ganz oder teilweise in das Linsensystem eingebettet sind.

Das optoelektronische Modul kann insbesondere zumindest näherungsweise randlos ausgestaltet sein. Insbesondere kann ein minimaler Abstand zwischen den optoelektronischen Komponenten und einem Rand des Trägers und/oder zwischen dem Linsensystem und einem Rand des Trägers weniger als 10 mm betragen, vorzugsweise weniger als 5 mm und besonders bevorzugt weniger als 3 mm. Typische Abstände liegen bei unter 5 mm, beispielsweise bei 0,5 mm bis 2 mm.

In einem weiteren Aspekt der vorliegenden Erfindung wird eine optoelektronische Vorrichtung vorgeschlagen. Unter einer optoelektronischen Vorrichtung ist allgemein eine Vorrichtung zu verstehen, welche mindestens eine optoelektronische Funktion durchführen kann, beispielsweise eine Funktion einer Lichtemission und/oder eine Funktion einer Fotodetektion. Die optoelektronische Vorrichtung kann beispielsweise ganz oder teilweise als Beleuchtungsvorrichtung ausgestaltet sein.

Die optoelektronische Vorrichtung umfasst mindestens zwei optoelektronische Module gemäß der vorliegenden Erfindung, also beispielsweise in einer oder mehreren der oben beschriebenen oder nachfolgend noch beschriebenen Ausgestaltungen. Die Träger der optoelektronischen Module sind in der optoelektronischen Vorrichtung benachbart zueinander angeordnet, vorzugsweise mit einem Abstand von weniger als 10 mm, beispielsweise mit einem Abstand von weniger als 1,0 mm.

Beispielsweise können die Träger der optoelektronischen Module zumindest näherungsweise parallel zueinander angeordnet sein, beispielsweise mit einer Winkelabweichung von einer parallelen Anordnung von weniger als 10°, vorzugsweise von weniger als 5°.

Es sind jedoch auch Anwendungen denkbar, bei denen die Träger in einer nicht-parallelen Anordnung zueinander ausgerichtet sein können. So ist kann im Rahmen der vorliegenden Erfindung die Vorrichtung auch derart realisiert werden, dass die Träger der optoelektronischen Module gegeneinander geneigt ausgerichtet sind, beispielsweise um eine gezielte, dreidimensionale Ausleuchtung eines Raumwinkelbereichs zu erreichen. Diesbezüglich kann beispielsweise auf die nachveröffentlichte deutsche Patentanmeldung DE 10 2010 013 286 aus dem Hause der Anmelderin der vorliegenden Anmeldung verwiesen werden. Die dort dargestellten Anordnungen und Vorrichtungen können auch im Rahmen der vorliegenden Erfindung mit entsprechender erfindungsgemäßer Modifikation realisiert werden. So ist beispielsweise eine optoelektronische Vorrichtung realisierbar, welche eine Mehrzahl erfindungsgemäßer optoelektronischer Module, insbesondere optoelektronischer Chip-On-Board-Module, umfasst, die wenigstens paarweise aneinander angrenzend oder in einem vorgegebenen Abstand zueinander angeordnet sind, wobei jedes optoelektronische Modul eine Mehrzahl von LEDs aufweist, beispielsweise jeweils mindestens ein LED-Array, wobei wenigstens ein Paar benachbarter optoelektronischer Module bezüglich ihrer Flächennormalen, beispielsweise der Flächennormalen ihrer Träger, unter einem Winkel angeordnet ist, der größer ist als 0°, beispielsweise größer ist als 5°, beispielsweise größer ist als 10°, beispielsweise größer ist als 15°, beispielsweise größer ist als 20°, beispielsweise größer ist als 30°. Beispielsweise können, wie unten noch näher ausgeführt wird, die Träger auf Seitenflächen eines fiktiven oder realen zylindrischen Körpers angeordnet sein, welcher eine polyedrische Grundfläche aufweisen kann. Dabei können die Außenseiten oder auch die Innenseiten der Träger mit den optoelektronischen Komponenten bestückt sein. Beispielsweise kann der Winkel zwischen den Flächennormalen benachbarter Träger bei einem Zylinder mit oktagonaler Grundfläche 45 ° betragen, und bei einem Zylinder mit hexagonaler Grundfläche 60°. Der Winkel kann starr ausgestaltet sein, beispielsweise durch eine Fixierung der optoelektronischen Module zueinander, kann jedoch auch variabel ausgestaltet sein, beispielsweise verstellbar.

Beispielsweise können die Module der optoelektronischen Vorrichtung eine längserstreckte Beleuchtungsvorrichtung ergeben, die wenigstens abschnittsweise entlang ihrer Längserstreckung einen unregelmäßigen oder regelmäßigen polygonalen Querschnitt aufweist oder zu einer regelmäßigen oder unregelmäßigen polyedrischen Form, insbesondere zu einem platonischen oder archimedischen Körper, angeordnet sind. Die optoelektronische Vorrichtung kann insbesondere eine Beleuchtungsvorrichtung bilden, deren Form flexibel ist.

Die optoelektronische Vorrichtung, beispielsweise die Beleuchtungsvorrichtung, mit den zueinander geneigten optoelektronischen Modulen kann beispielsweise derart ausgestaltet sein, dass die LEDs der optoelektronischen Module nach außen weisen oder in einen Hohlraum der Vorrichtung hinein weisen.

Durch die Anordnung mehrerer zueinander geneigter optoelektronischer Module, beispielsweise mit Neigungen der Flächennormalen von mehr als 10° zueinander, können beispielsweise gezielt dreidimensionale Formen realisiert werden, und/oder es kann ein Feldüberlapp gezielt beeinflusst werden. Insbesondere kann dies durch eine positionsabhängige Optikformung erfolgen, um auch bei dreidimensionalen Formen gezielte Feldverteilungen erreichen zu können. Beispielsweise können zwei oder mehr optoelektronische Module und/oder deren Träger in einer erfindungsgemäßen Vorrichtung auf Zylinderflächen angeordnet sein oder Zylinderflächen bilden, wobei die Zylinder beispielsweise eine sechseckige oder achteckige Grundfläche aufweisen können. So können beispielsweise um eine Achse des Zylinders zumindest näherungsweise zirkular homogene Feldverteilungen erreicht werden.

Inbesondere können die Träger der optoelektronischen Module derart angeordnet sein, dass bestückte Seiten der Träger der optoelektronischen Module in dieselbe Richtung weisen. Bei einer nicht-parallelen Ausrichtung der Träger zueinander können, wie oben ausgeführt, die bestückten Seiten der optoelektronischen Module jedoch auch in unterschiedliche Richtungen weisen, beispielsweise um eine gezielte dreidimensionale Ausleuchtung zu erreichen.

In einem weiteren Aspekt der vorliegenden Erfindung wird ein Verfahren zur Herstellung eines optoelektronischen Moduls gemäß der vorliegenden Erfindung vorgeschlagen, also eines optoelektronischen Moduls beispielsweise gemäß einer oder mehreren der oben beschriebenen oder nachfolgend noch beschriebenen Ausgestaltungen. Zur Herstellung des optoelektronischen Moduls können grundsätzlich bekannte Verfahren eingesetzt werden, beispielsweise die oben beschriebenen, aus dem Stand der Technik bekannten Verfahren. Insbesondere können die in DE 10 2010 044 470 und/oder in DE 10 2010 044 471 beschriebenen Verfahren eingesetzt werden, um ein optoelektronisches Modul gemäß der vorliegenden Erfindung oder Teile desselben herzustellen. Auf diese Herstellungsverfahren wird dementsprechend im Rahmen der vorliegenden Erfindung vollumfänglich Bezug genommen. So kann insbesondere ein Verfahren verwendet werden, bei welchem zunächst der Träger auf eine erste Temperatur vorgewärmt wird. Anschließend kann auf den vorgewärmten Träger mindestens ein Damm aus einem ersten, thermisch aushärtenden hochreaktiven Silikon aufgebracht werden, das bei der ersten Temperatur aushärtet, wobei der Damm eine zu beschichtende Fläche oder Teilfläche des Trägers ganz oder teilweise umschließt. Anschließend kann die von dem Damm eingeschlossene Fläche oder Teilfläche des Trägers mit einem flüssigen zweiten Silikon vollständig oder teilweise aufgefüllt werden, und das zweite Silikon kann ausgehärtet werden. Mittels des ersten Silikons und/oder des zweiten Silikons können eine, mehrere oder alle Linsen des Linsensystems hergestellt werden. Für weitere Ausgestaltungen kann auf die DE 10 2010 044 470 verwiesen werden. Alternativ oder zusätzlich können das optoelektronische Modul und/oder das Linsensystem ganz oder teilweise gemäß dem in DE 10 2010 044 471 beschriebenen Verfahren hergestellt werden. So kann insbesondere ein Vergießen eines flüssigen Silikons in eine nach oben offene Form erfolgen, welche, insbesondere in mindestens einem Formnest, Außenmaße aufweist, die den Außenmaßen des Trägers entsprechen oder diese übersteigen. Weiterhin kann der Träger in die Form eingeführt werden, wobei mindestens eine der optoelektronischen Komponenten oder vorzugsweise alle der optoelektronischen Komponenten vollständig in das Silikon eingetaucht werden und eine Oberfläche des Trägers das Silikon vollflächig berührt, öder der Träger wenigstens teilweise vollflächig in das Silikon eintaucht. Weiterhin kann das Silikon ausgehärtet und vernetzt werden, mit den optoelektronischen Komponenten und dem Träger. Weiterhin kann der Träger mit der Beschichtung aus dem ausgehärteten Silikon aus der Form entnommen werden. Die Form kann insbesondere derart ausgestaltet sein, dass mittels der Form, beispielsweise mindestens eines Formnests der Form, das Linsensystem mit den mindestens zwei Linsen aus dem Silikon geformt wird.

Allgemein kann zur Herstellung eines optoelektronischen Moduls gemäß der vorliegenden Erfindung insbesondere ein Verfahren verwendet werden, bei welchem das Linsensystem derart hergestellt wird, dass mindestens ein verformbarer Ausgangswerkstoff des Linsensystems, beispielsweise mindestens ein Silikon, mit den optoelektronischen Komponenten und vorzugsweise auch dem Träger in Kontakt gebracht, geformt und ausgehärtet wird. Für mögliche Ausgestaltungen dieses Verfahrens kann auf die obige Beschreibung und insbesondere den oben genannten Stand der Technik verwiesen werden.

In einem weiteren Aspekt der vorliegenden Erfindung wird die Verwendung eines erfindungsgemäßen optoelektronischen Moduls, beispielsweise gemäß einer oder mehreren der oben beschriebenen oder auch nachfolgend noch näher beschriebenen Ausgestaltungen, für eine Belichtungsanwendung und/oder eine Bestrahlungsanwendung vorgeschlagen. Insbesondere kann es sich bei dieser Anwendung um eine Anwendung zur Bestrahlung mit ultraviolettem und/oder infrarotem Licht handeln. Bei dieser Belichtungsanwendung und/oder Bestrahlungsanwendung wird mindestens ein Werkstück, wobei es sich um ein Ausgangsmaterial und/oder um ein bereits geformtes Werkstück handeln kann, mit von dem optoelektronischen Modul emittierten elektromagnetischen Strahlen bestrahlt. Diese elektromagnetischen Strahlen können beispielsweise Licht im ultravioletten und/oder sichtbaren und/oder infraroten Spektralbereich umfassen. Vorzugsweise kann diese Bestrahlung zum Zweck einer Trocknung und/oder Härtung und/oder zum Zweck einer fotochemischen Modifikation des Werkstücks oder Teilen desselben erfolgen.

Das vorgeschlagene optoelektronische Modul, die vorgeschlagene optoelektronische Vorrichtung, das Verfahren und die Verwendung weisen gegenüber bekannten Vorrichtungen, Verfahren und Verwendungen der genannten Art eine Vielzahl von Vorteilen auf. Insbesondere lässt sich eine effiziente und anreihbare Lichtquelle realisieren, deren Beleuchtungsprofil in einem einstellbaren Abstand eine sehr hohe Bestrahlungsstärke besitzt. Weiterhin lassen sich erfindungsgemäß hohe Homogenitätsanforderungen erfüllen und gleichzeitig optional in einem Randbereich ein genügend steiler Abfall der Beleuchtung realisieren. Insbesondere lassen sich Verwendungen im Bereich einer industriellen Fertigung realisieren, beispielsweise in einer Druckindustrie bei Lithografieanwendungen, um ein gleichmäßiges und qualitativ hochwertiges Trocknungsbild bei Druckfarben und/oder Tinten- und/oder Fotolacken zu erzielen. Insbesondere lassen sich Bestrahlungsstärken von mehr als 100 mW/cm², vorzugsweise von mehr als 1-20 W/cm², bis hin zu 100 W/cm² realisieren, um hohe Prozessgeschwindigkeiten bei möglichst kompakten und energieeffizienten Lichtquellen zu erreichen. Insbesondere lassen sich maßgeschneiderte optoelektronische Module und/oder optoelektronische Vorrichtungen für bestimmte Anwendungen realisieren.

Insbesondere können das optoelektronische Modul oder die optoelektronische Vorrichtung ganz oder teilweise als Leuchtdioden-Lichtquelle ausgestaltet sein. Diese Leuchtdioden-Lichtquelle kann auf der Basis von LED-Arrays realisiert werden, die aufgrund einer optionalen, nahezu randlosen Aufbringung einer Gussoptik quasi lückenlos, beispielsweise mit einem Abstand von weniger als 10 mm, angereiht werden können, um eine homogene Feldverteilung zu erreichen. Dabei lassen sich auch größere Abstände von LED-Arrays zueinander durch die oben beschriebene Möglichkeit zur positionsabhängigen Formung der Linsenoptik des Linsensystems kompensieren.

Bei einer Aneinanderreihung summieren sich insbesondere die Lichtströme der einzelnen LED-Arrays insbesondere im Überlappungsbereich der Emissionen. Um die Homogenitätsanforderungen auch in den Bereichen, in denen sich die Strahlungen von zwei bzw. mehreren LED-Arrays überlappen, zu erfüllen, sollte die Emission eines einzelnen LED-Arrays insbesondere im Randbereich darauf abgestimmt sein.

Um die Homogenitätsanforderungen zu erfüllen und gleichzeitig beispielsweise eine steil abfallende Bestrahlungsstärke am äußeren Rand mehrerer Arrays zu erzielen, können die Linsenformen eines Arrays der Linsenanordnung in Anreihrichtung variiert werden. Insbesondere kann ein steiler Abfall einer Bestrahlungsstärke in einem Randbereich notwendig sein, um die Lampe in der Raumrichtung, in der die Homogenitätsanforderung gilt, möglichst klein ausgestalten zu können.

Die mittleren Linsen eines Linsenarrays können beispielsweise eher streuend ausgestaltet sein, also beispielsweise mit einem stärkeren Öffnungswinkel, und die äußeren Linsen können eher kollimierend ausgelegt sein. Dadurch wird beispielsweise generell Licht aus der Arraymitte in die Randbereiche umgelegt, und dadurch kann die Bestrahlungsstärke im Randbereich stärker abfallen. Weiterhin kann die Bestrahlungsstärke in einer der LED-Lampe entsprechenden Fläche vor der Lampe in einem definierten Abstand homogenisiert werden, wobei der Bereich der homogenen Fläche maximiert werden kann.

Wie oben ausgeführt, können diese Vorteile im Rahmen der Erfindung auf verschiedene Weisen realisiert werden. Insbesondere können Linsen vorgesehen sein, welche Bereiche mit konvexer Krümmung und konkaver Krümmung aufweisen. So kann beispielsweise eine Krümmung von einem konvexen Verlauf, insbesondere bei Betrachtung des Querschnitts durch eine Linsenmitte in einer Raumrichtung, zu einem in der Linsenmitte konkaven Bereich übergehen. Je nach Auslegung dieses Bereichs kann die Linse dann eher kollimierend oder eher streuend wirken.

Alternativ oder zusätzlich kann dieser Effekt durch eine Variation der Linsenhöhe der einzelnen Linsen über den optoelektronischen Komponenten, insbesondere den LEDs, verstärkt werden. Im Gegensatz hierzu sind aus dem Stand der Technik in der Regel Linsensysteme mit identischen Linsen bekannt, beispielswese mit einer flachen Ausgestaltung der Linsen im Zentrum, wie insbesondere in US 7,819,550 B2 beschrieben. Im Gegensatz zum Stand der Technik können somit erfindungsgemäß Anforderungen an Homogenität und/oder an einen steil abfallenden Randbereich hinreichend erfüllt werden. Der durch die erfindungsgemäße Ausgestaltung zu leistende Mehraufwand hält sich aufgrund der Möglichkeit einmaliger Designänderungen beispielsweise entsprechender Formen für die Herstellung des Linsensystems in einem vertretbaren Rahmen, insbesondere im Hinblick auf das erzielbare Ergebnis hinsichtlich einer Steigerung der Energieeffizienz und einer Kompaktheit des optoelektronischen Moduls und der optoelektronischen Vorrichtung.

Durch eine geeignete Ausgestaltung des Linsensystems und der Ortsabhängigkeit der Richtcharakteristik der Linsen können weitere vorteilhafte Effekte erzielt werden. Insbesondere lässt sich ein zusätzlich steilerer Abfall der Bestrahlungsstärke in einem Randbereich erzielen durch eine gezielte Dezentrierung zwischen einer Linse und einer zugeordneten optoelektronischen Komponente, beispielsweise einer zugeordneten Leuchtdiode. Alternativ oder zusätzlich lässt sich eine Dezentrierung einer Linse zu den LEDs in einer Anreihrichtung erzielen. Beispielsweise lässt sich ein Array optoelektronischer Komponenten und ein Array von Linsen verwenden, wobei verschiedene Möglichkeiten hinsichtlich des Pitchs dieser Arrays realisierbar sind. Beispielsweise lässt sich ein homogener Pitch des Arrays der optoelektronischen Komponenten mit einem inhomogenen Pitch des Linsenarrays kombinieren oder umgekehrt. Auch ein inhomogener Pitch des Arrays der optoelektronischen Komponenten mit einem inhomogenen Pitch des Linsenarrays ist denkbar.

Eine Anreihung mehrerer optoelektronischer Module in einer optoelektronischen Vorrichtung kann in einer oder auch in zwei Raumrichtungen erfolgen. Weiterhin lässt sich auch eine asymmetrische Linsenform realisieren. Eine Linsengröße, insbesondere eine Grundfläche der Linsen und/oder eine Höhe, kann positionsabhängig innerhalb des Linsensystems variiert werden. Darüber hinaus lassen sich die erfindungsgemäßen Maßnahmen, einzeln oder in Kombination, auch nutzen, um eine gezielte Erhöhung einer Bestrahlungsstärke in bestimmten Bereichen eines zu beleuchtenden Bereichs zu erreichen. In der Regel ist dies beispielsweise mit einem flacheren Abfall in einem Randbereich einer Lampe verbunden. Eine Kombination der oben genannten Maßnahmen kann insbesondere eine homogene Verteilung mit einer Bestrahlungsstärke auf einem insgesamt hohen Niveau des zur Verfügung stehenden Lichtstroms in einem einstellbaren Arbeitsabstand resultieren.

Durch die erfindungsgemäßen Maßnahmen, einzeln oder in Kombination, lassen sich weiterhin die Vorteile der Chip-on-Board-Technologie einsetzen, um einen hohen Lichtstrom aus einer verhältnismäßig kleinen Fläche des optoelektronischen Moduls zu erzielen. Insbesondere lassen sich möglichst hohe LED-Packungsdichten und ein gutes thermisches Management erzielen. Insbesondere durch die oben beschriebene bevorzugte Ausgestaltung einer Vergussoptik kann das Licht effizient genutzt werden, um das gewünschte Beleuchtungsprofil in einem bestimmten Abstand, beispielsweise 2 mm bis zu einigen 10 cm über dem optoelektronischen Modul, beispielsweise dem LED-Chip, zu erzeugen. Beispielsweise können Abstände von typischerweise 5-200 mm, abhängig von der Größe des optoelektronischen Moduls und/oder der optoelektronischen Vorrichtung, eingesetzt werden. Allgemein können beispielsweise Bestrahlungsstärken von mehr als 100 mW/cm² eingesetzt werden, typischerweise 1-20 W/cm², bis hin zu typischerweise 100 W/cm². Gleichzeitig können das Linsensystem, insbesondere eine Vergussoptik des Linsensystems, die optoelektronischen Komponenten, beispielsweise die LEDs, auch vor äußeren Einflüssen wie Schmutz, Feuchtigkeit und mechanischen Einflüssen schützen.

Die Wirkung der einzelnen Linsen kann an die genaue Array-Position der optoelektronischen Komponenten, insbesondere der LEDs, angepasst werden. Dies kann beispielsweise durch eine Variation der Linsenform der Linsen und der Linsenposition gegenüber den optoelektronischen Komponenten, beispielsweise den LEDs, oder umgekehrt erfolgen. Dadurch ist es möglich, unabhängig davon, ob ein Nachbar-Array existiert oder nicht, in einem bestimmten Abstand eine homogene Bestrahlungsstärke zu erhalten und gleichzeitig optional einen scharf ausgeprägten Randbereich an außen liegenden Arrays zu erzielen. Dadurch kann in einem bestimmten Abstand effizient die Zielverteilung der Bestrahlungsstärke erreicht werden. Der steile Randabfall kann die benötigte Lampenlänge minimieren und die Kosten senken, wobei gleichzeitig eine Kompaktheit erhöht werden kann. Die Anreihbarkeit der Leuchtdioden-Lichtquelle aus einzelnen Arrays kann eine große Freiheit in der realisierbaren Gesamtgröße gewährleisten. Die optoelektronische Vorrichtung kann insbesondere modular aufgebaut sein. In einer modularen Aufbauweise mit mehreren modular aneinander gesetzten optoelektronischen Modulen kann, beispielsweise bei einem defekten optoelektronischen Modul und/oder einem defekten Array, ein Austausch dieses optoelektronischen Moduls bzw. Arrays erfolgen. Dies kann die dadurch entstehenden Kosten bei einem Austausch deutlich senken und den damit verbundenen Service vereinfachen.

Die Beeinflussung der Richtcharakteristik, beispielsweise die Beeinflussung der Bestrahlungsstärkenverteilung vor einem LED-Modul, kann in beide Raumrichtungen senkrecht zum Normalen der Emissionsfläche auch getrennt optimierbar sein. Prinzipiell lassen sich auch bei dreidimensionalen LED-Array-Anordnungen, beispielsweise gegeneinander gekippten LED-Arrays oder flexiblen Substraten, gezielte Feldverteilungen durch die beschriebenen erfindungsgemäßen Ausgestaltungen erzielen.

Bei Bedarf kann der oben beschriebene Effekt eines steilen Randabfalls auch umgekehrt und in das Gegenteil verwandelt werden. Durch einen bewusst flach gehaltenen Randabfall kann das zur Verfügung stehende Licht auf andere Weise verteilt werden. So kann beispielsweise statt einer über die gesamte Lampenlänge homogenen Bestrahlungsstärke zentral vor den einzelnen Arrays eine hohe Bestrahlungsstärke erzeugt werden.

Insgesamt lässt sich erfindungsgemäß insbesondere ein auf verschiedene Prozessgeometrien und Prozessabläufe anpassbares modulares System aus High-Power-LED-Arrays generieren, die eine hohe Effizienz im Betrieb erzielen können. Das gute thermische Management der LED-Arrays und eine effiziente Mikrooptik können zudem die Freiheit gewähren, je nach Anforderungen, die LED-Lichtquelle auf Basis einer Wasser- oder einer Luftkühlung auszulegen.

Die Erfindung wird nachstehend ohne Beschränkung des allgemeinen Erfindungsgedankens anhand von Ausführungsbeispielen unter Bezugnahme auf die schematischen Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig.1: ein Ausführungsbeispiel einer optoelektronischen Vorrichtung mit einer Mehrzahl von nahezu randlosen optoelektronischen Modulen, die aneinander angereiht sind;
- Fig. 2A-4B: jeweils optoelektronische Vorrichtungen mit mehreren optoelektronischen Modulen sowie zugehörige Abstrahlcharakteristiken;
- Fig. 5: eine vergrößerte Darstellung eines erfindungsgemäßen optoelektronischen Moduls mit ortsabhängiger Abstrahlcharakteristik; und
- Fig. 6A-7B: jeweils wieder optoelektronische Vorrichtungen mit mehreren optoelektronischen Modulen und zugehöriger Abstrahlcharakteristik.

In den folgenden Figuren sind jeweils gleiche oder gleichartige Elemente bzw. entsprechende Teile mit denselben Bezugsziffern versehen, so dass von einer entsprechenden erneuten Vorstellung abgesehen wird.

Die Erfindung wird insbesondere und ohne Beschränkung weiterer möglicher Ausgestaltungen anhand von Chip-On-Board-LED-Modulen, also anhand von Leuchtkörpern, als Beispiel für optoelektronische Module und insbesondere für Chip-On-Board-Module, erläutert. Im Rahmen der Erfindung können anstatt von LED-Modulen als optoelektronische Komponenten auch Photodioden in Solarzellen oder andere Komponenten Anwendung finden.

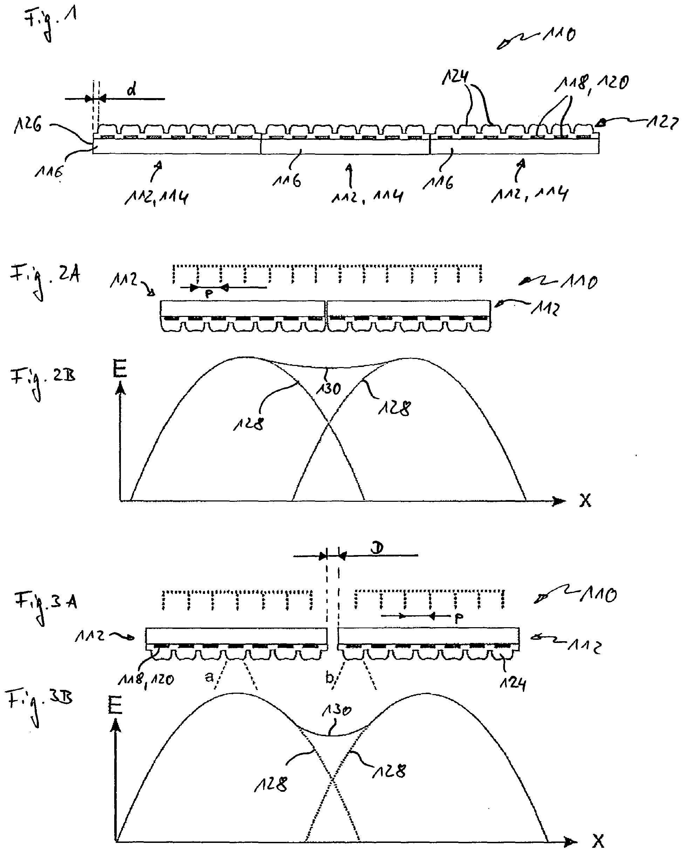

In Figur 1 ist ein erstes Ausführungsbeispiel einer optoelektronischen Vorrichtung 110 dargestellt, welche aus mehreren, in diesem Fall 3, aneinander angereihten optoelektronischen Modulen 112 zusammengesetzt ist. Die optoelektronische Vorrichtung 110 kann beispielsweise als Bestrahlungsvorrichtung ausgestaltet sein. Die optoelektronischen Module 112 können beispielsweise jeweils als Chip-on-Board-Module 114 ausgestaltet sein.

Die optoelektronischen Module 112 umfassen jeweils einen Träger 116, welcher zumindest teilweise flächig ausgestaltet ist und auf welchen, beispielsweise in einer Chip-on-Board-Technik, optoelektronische Komponenten 118, beispielsweise ungehäuste optoelektronische Komponenten 118, aufgebracht sind. Ohne Beschränkung weiterer Ausgestaltungen wird im Folgenden angenommen, dass es sich bei diesen optoelektronischen Komponenten 118 um Leuchtdioden 120 handelt. Die optoelektronischen Komponenten 118 sind in einem Array auf dem Träger 118 angeordnet, sodass beispielsweise ein Leuchtdioden-Array entsteht.

Weiterhin weisen die optoelektronischen Module 112 jeweils mindestens ein Linsensystem 122 auf, beispielsweise ein Mikrolinsensystem, welches sich in dem dargestellten Ausführungsbeispiel als Array von Linsen 124, beispielsweise Mikrolinsen, darstellt. Die Linsen 124 weisen, wie unten noch näher erläutert wird, eine ortsabhängige Richtcharakteristik, insbesondere eine ortsabhängige Abstrahlcharakteristik, auf, sodass sich innerhalb der optoelektronischen Module 112 jeweils Linsen 124 befinden, welche, gegebenenfalls in Zusammenwirkung mit der zugehörigen optoelektronischen Komponente 118 bzw. der zugeordneten Leuchtdiode 120, voneinander abweichende Richtcharakteristiken aufweisen.

Das Linsensystem 122 kann beispielsweise mit einer Vergusstechnik hergestellt werden. Hierfür können beispielsweise die oben beschriebenen Verfahren eingesetzt werden. Insbesondere lässt sich mit derartigen Vergusstechniken oder auch mit anderen Techniken eine nahezu randlose Ausgestaltung der optoelektronischen Module 112 erzielen, sodass beispielsweise ein Abstand d zwischen einer äußersten Linse 124 und einem Rand 126 des Trägers 116 weniger als 10 mm beträgt, vorzugsweise weniger als 5 mm und insbesondere weniger als 3 mm. Durch die nahezu randlose Aufbringung der Vergussoptik ist eine quasi lückenlose Anreihung der Arrays der Leuchtdioden 120 möglich.

Wie in den Figuren 2A und 2B dargestellt, addieren sich die Richtcharakteristiken der einzelnen optoelektronischen Komponenten 118 auf jedem optoelektronischen Modul 112 jeweils zu einer Gesamt-Richtcharakteristik für das optoelektronische Modul 112. Dabei zeigt Figur 2A, einer zu Figur 1 analogen, jedoch invertierten Darstellung eine optoelektronische Vorrichtung 110 mit zwei optoelektronischen Modulen 112. Figur 2B zeigt Gesamt-Richtcharakteristiken der einzelnen optoelektronischen Komponenten 118 der optoelektronischen Module 112, dort jeweils mit der Bezugsziffer 128 bezeichnet. Mit der Bezugsziffer 130 ist die Summe dieser Gesamt-Richtcharakteristiken 120 der einzelnen optoelektronischen Module 112 bezeichnet. Als Richtcharakteristik ist hier ein Messwert einer elektrischen Feldstärke E in einem vorgegebenen Abstand zur optoelektronischen Vorrichtung 110 verwendet, wobei eine Messung entlang einer Ortskoordinate x parallel zu einer Oberfläche der optoelektronischen Module 112 erfolgt. Auch eine andere Art der Messung der Richtcharakteristik ist jedoch grundsätzlich möglich, beispielsweise eine winkelabhängige Messung relativ zu einer Winkelnormalen der lichtemittierenden Fläche der optoelektronischen Vorrichtung 110.

Werden LED-Arrays, wie in Figur 2A, aneinander gereiht, so addieren sich deren Lichtströme. Ein Abstand zwischen den Mittelpunkten der einzelnen optoelektronischen Module 112 wird allgemein als Pitch p bezeichnet. Bei einer Anreihung, bei welcher der Abstand zwischen den LEDs konstant bleibt, d.h. bei einer Pitch erhaltenden Anreihung, ist die resultierende Bestrahlungsstärke in einem bestimmten Abstand somit weitgehend homogen.

In den Figuren 3A und 3B ist demgegenüber eine Ausgestaltung in zu den Figuren 2A und 2B analoger Darstellung gezeigt, bei welchen zwischen den optoelektronischen Modulen 112 ein größerer Abstand D auftritt. Dementsprechend handelt es sich hierbei um eine nicht-Pitcherhaltende Anreihung der optoelektronischen Module 112. Dementsprechend ist die resultierende Bestrahlungsstärke in einem Bereich zwischen den optoelektronischen Modulen 112 nicht homogen.

Weiterhin sind in Figur 3A Abstrahlcharakteristiken einzelner Linsen 124, in Zusammenwirkung mit den zugehörigen optoelektronischen Komponenten 118 bzw. Leuchtdioden 120, symbolisch dargestellt und mit a und b bezeichnet. Beispielsweise kann es sich hierbei um Randstrahlen handeln, welche entlang einer Linie verlaufen, bei welcher eine elektrische Feldstärke und/oder eine Intensität auf die Hälfte eines Maximalwerts abgesunken sind.

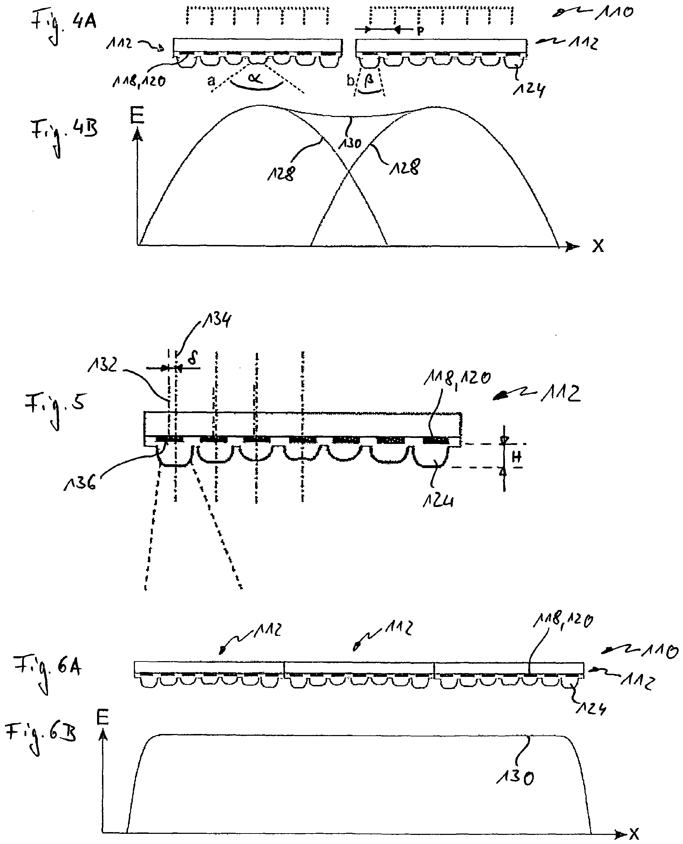

In Figur 4A und 4B ist, in einer zu den Figuren 3A und 3B analogen Darstellung, der Effekt einer Variation der Richtcharakteristik der Linsen 124 dargestellt. So ist eine Linse 124 in einem Inneren des Linsenarrays gezeigt, welche eine Abstrahlcharakteristik a aufweist, gegebenenfalls in Zusammenwirkung mit der zugehörigen optoelektronischen Komponente 118 bzw. Leuchtdiode 120, wohingegen eine Linse 124 an einem Rand des Linsensystems 122 eines optoelektronischen Moduls 112 eine Abstrahlcharakteristik b aufweist. Beispielsweise kann die Abstrahlcharakteristik a einen Abstrahlwinkel α aufweisen, wohingegen die Abstrahlcharakteristik b einen Abstrahlwinkel β aufweist. Diese unterschiedlichen Abstrahlcharakteristiken a, b lassen sich beispielsweise durch eine Variation der Linsenform und/oder der Linsenhöhe und/oder der Ausrichtung der Linse 124 zur zugeordneten optoelektronischen Komponente 118 erzielen. Beispielsweise kann eine Variation der Linsenform der Linsen 124 in einer Anreihrichtung auch bei einer nicht-Pitch-erhaltenden Anreihung in einem bestimmten Abstand eine weitestgehend homogene Bestrahlungsstärke erzeugen. Dementsprechend ist durch Variation der Richtcharakteristika beispielsweise die Gesamt-Richtcharakteristik 130 gemäß Figur 4B in einem Bereich zwischen den optoelektronischen Modulen 112 erheblich homogener als bei der Ausgestaltung gemäß den Figuren 3A und 3B. Beispielsweise können mittlere Linsen 124 der Linsenarrays eher streuend ausgestaltet werden, wie in Figur 4A gezeigt, und Linsen an einem Rand des Linsenarrays eher kollimierend ausgelegt werden, wie in Figur 4A durch den kleineren Abstrahlwinkel β gezeigt.

Eine Variation der Richtcharakteristika der Linsen 124 lässt sich, wie oben beschrieben, auf verschiedene Weisen erzielen, die auch kombiniert werden können. So ist beispielsweise in Figur 5 ein optoelektronisches Modul dargestellt, bei welchem die Linsen 124 gezielt gegenüber den zugeordneten optoelektronischen Komponenten 118, beispielsweise den Leuchtdioden 120, dezentriert und/oder auf andere Weise versetzt werden. So können beispielsweise optische Achsen 132, 133 für die optoelektronischen Komponenten 118 bzw. die zugeordneten Linsen 124 definiert werden. Beispielsweise kann eine optische Achse 132 für jede optoelektronische Komponente 118 definiert werden als eine Gerade, welche zentrisch durch eine aktive Fläche 136, beispielsweise eine Abstrahlfläche, der optoelektronischen Komponenten 118 verläuft. Als optische Achse 134 der Linse kann beispielsweise eine Symmetrieachse der Linse 124 verstanden werden, wobei jedoch grundsätzlich auch asymmetrische Ausgestaltungen möglich sind. Wie in Figur 5 dargestellt, können die optischen Achsen 132, 134 der einander zugeordneten Komponenten 118, 124 parallel gegeneinander versetzt sein. Dieser Parallelversatz, welcher in Figur 5 symbolisch mit δ bezeichnet ist, kann ortsabhängig ausgestaltet sein, wie in Figur 5 gezeigt. So kann in einer Mitte des Linsenarrays ein Versatz δ = 0 auftreten, wohingegen in einem Randbereich des Linsenarrays ein größtmöglicher Versatz auftreten kann. Hierdurch ergibt sich in einem Randbereich des Linsenarrays eine asymmetrische Richtcharakteristik, welche in dem dargestellten Ausführungsbeispiel exemplarisch stärker ins Zentrum des Linsensystems gerichtet ist. Alternativ oder zusätzlich zu einem reinen Parallelversatz der optischen Achsen 132, 134 kann auch ein Winkelversatz auftreten. Weiterhin ist in Figur 5 auch gezeigt, dass eine Höhe H der Linsen 124 alternativ oder zusätzlich variiert werden kann, wie auch eine Form der Linsen 124. Insgesamt lässt sich, durch eine, mehrere oder alle der genannten Maßnahmen beispielsweise ein zusätzlicher steilerer Randabfall der Gesamt-Richtcharakteristik 130 für ein einzelnes optoelektronisches Modul 112 oder eine gesamte optoelektronische Vorrichtung 110 erzielen.

In den Figuren 6A und 6B sind, in einer beispielsweise zu den Figuren 2A und 2B analogen Darstellung, ein Schnitt durch eine optoelektronische Vorrichtung 110 mit drei optoelektronischen Modulen 112, beispielsweise jeweils gemäß der Ausgestaltung in Figur 5, und eine zugehörige Gesamt-Richtcharakteristik 130 (Figur 6B) dargestellt. Beispielsweise können, wie oben ausgeführt, die Linsenformen der Linsen 124 in einer Anreihrichtung (beispielsweise Richtung X in Figur 6B) variiert werden und/oder die Linsen 124 können, in Abhängigkeit von ihrer Arrayposition, relativ zu den optoelektronischen Komponenten 118 bzw. Leuchtdioden 120 dezentriert werden, und/oder die Linsenhöhe H kann in Abhängigkeit von der Arrayposition variiert werden. Als Resultat kann sich beispielsweise, wie in Figur 6B erkennbar, eine homogene Verteilung mit einer hohen Bestrahlungsstärke in einem einstellbaren Arbeitsabstand ergeben.

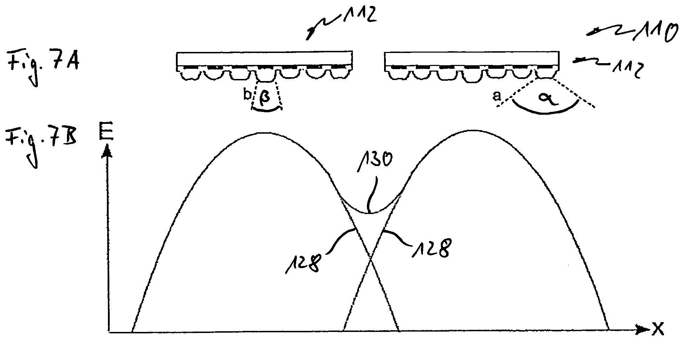

Während in dem Ausführungsbeispiel gemäß den Figuren 4A und 4B bei Linsen 124 in einem Randbereich des Linsenarrays eine Richtcharakteristik mit geringerem Öffnungswinkel β gewählt wurde als in einem mittleren Bereich, lassen sich grundsätzlich, alternativ oder zusätzlich, auch andere Ausgestaltungen realisieren. So ist beispielsweise in den Figuren 7A und 7B eine Ausgestaltung gezeigt, bei welcher, beispielsweise durch eine, mehrere oder alle der oben gezeigten Maßnahmen, Linsen in einem inneren Bereich eines Linsenarrays einen geringeren Abstrahlwinkel β aufweisen als Linsen in einem Randbereich (Öffnungswinkel a). Ein flacherer Randabfall kann insgesamt beispielsweise genutzt werden, um eine zusätzlich erhöhte Bestrahlungsstärke in einem vorgegebenen, beispielsweise einstellbaren, Arbeitsabstand zu der optoelektronischen Vorrichtung 110 zu gewährleisten.

### Bezugszeichenliste

- 110: optoelektronische Vorrichtung
- 112: optoelektronisches Modul
- 114: Chip-on-Board-Modul
- 116: Träger
- 118: optoelektronische Komponente
- 120: Leuchtdiode
- 122: Linsensystem
- 124: Linse
- 126: Rand
- 128: Gesamt-Richtcharakateristik für optoelektronisches Modul
- 130: Gesamt-Richtcharakteristik für optoelektronische Vorrichtung
- 132: optische Achse der optoelektronischen Komponente
- 134: optische Achse der optoelektronischen Linse
- 136: aktive Fläche

## Patentansprüche

1. Optoelektronisches Modul (112), ausgebildet als optoelektronisches Chip-on-Board-Modul (114), wobei das optoelektronische Modul (112) einen Träger (116) umfasst, wobei der Träger (116) flächig ausgestaltet ist, weiterhin umfassend eine Mehrzahl von auf dem Träger (116) angeordneten optoelektronischen Komponenten (118), wobei das optoelektronische Modul (112) weiterhin ein Linsensystem (122) mit einer Mehrzahl von Linsen (124) umfasst, wobei die optoelektronischen Komponenten (118) in einem zweidimensionalen Array auf dem Träger (116) angeordnet sind;
das Linsensystem (122) mindestens zwei Linsen (124) mit unterschiedlicher Richtcharakteristik aufweist;
**dadurch gekennzeichnet, dass** die mindestens zwei Linsen (124) mit unterschiedlicher Richtcharakteristik Linsen (124) eine unterschiedliche Höhe umfassen;
wobei das Linsensystem (122) eine stufenweise Veränderung von Richtcharakteristiken aufweist;
wobei sich die Richtcharakteristiken von einem Inneren des Linsensystems (122) hin zu einem Rand des Linsensystems (122) kontinuierlich oder diskontinuierlich verändern;
wobei mindestens eine Linse (124) des Linsensystems (122) eine Oberflächenkrümmung mit mindestens einem konvex gekrümmten Bereich und mindestens einem konkav gekrümmten Bereich aufweist;
wobei die konvex gekrümmten und konkav gekrümmten Bereiche auf einer dem Träger (116) abgewandten Seite des Linsensystems (122) angeordnet sind.

2. Optoelektronisches Modul (112) nach dem vorhergehenden Anspruch, wobei die optoelektronischen Komponenten (118) in einer zweidimensionalen Matrix angeordnet sind.

3. Optoelektronisches Modul (112) nach einem der vorhergehenden Ansprüche, wobei die optoelektronischen Komponenten (118) ausgewählt sind aus der Gruppe bestehend aus Leuchtdioden (120), insbesondere Oberflächen-emittierenden Leuchtdioden, und Fotodioden.

4. Optoelektronisches Modul (112) nach einem der vorhergehenden Ansprüche, wobei die mindestens zwei Linsen (124) mit unterschiedlicher Richtcharakteristik Linsen (124) mit unterschiedlicher Oberflächenkrümmung umfassen.

5. Optoelektronisches Modul (112) nach einem der vorhergehenden Ansprüche, wobei die mindestens zwei Linsen (124) mit unterschiedlicher Richtcharakteristik Linsen (124) mit unterschiedlicher Grundfläche umfassen.

6. Optoelektronisches Modul (112) nach einem der vorhergehenden Ansprüche, wobei die mindestens zwei Linsen (124) mit unterschiedlicher Richtcharakteristik Linsen (124) umfassen, bei welchen jeweils eine optische Achse der Linse (124) in unterschiedlicher Weise zu jeweils einer optischen Achse der optoelektronischen Komponente (118) ausgerichtet ist.

7. Optoelektronisches Modul (112) nach einem der vorhergehenden Ansprüche, wobei das Linsensystem (122) mindestens eine Linse (124) umfasst, bei welcher eine optische Achse (134) der Linse (124) zu einer optischen Achse (132) einer der Linse (124) zugeordneten optoelektronischen Komponente (118) versetzt angeordnet ist.

8. Optoelektronisches Modul (112) nach einem der vorhergehenden Ansprüche, wobei das Linsensystem (122) derart ausgestaltet ist, dass jeder optoelektronischen Komponente (118) genau eine Linse (124) zugeordnet ist.

9. Optoelektronisches Modul (112) nach einem der vorhergehenden Ansprüche, wobei mindestens eine Linse (124) an einem Rand des Linsensystems (122) vorgesehen ist, wobei die Linse (124) einen kleineren Öffnungswinkel der Richtcharakteristik als mindestens eine in einem Inneren des Linsensystems (122) angeordnete Linse (124) aufweist.

10. Optoelektronisches Modul (112) nach einem der vorhergehenden Ansprüche, wobei mindestens eine Linse (124) an einem Rand des Linsensystems (122) vorgesehen ist, wobei die Linse (124) einen größeren Öffnungswinkel der Richtcharakteristik als mindestens eine in einem Inneren des Linsensystems (122) angeordnete Linse (124) aufweist.

11. Optoelektronisches Modul (112) nach einem der vorhergehenden Ansprüche, wobei der konkav gekrümmte Bereich ringförmig von dem konvex gekrümmten Bereich umgeben ist.

12. Optoelektronische Vorrichtung (110), umfassend mindestens zwei optoelektronische Module (112) nach einem der vorhergehenden Ansprüche, wobei die Träger (116) der optoelektronischen Module (112) in der optoelektronischen Vorrichtung (110) benachbart zueinander angeordnet sind.

13. Verfahren zur Herstellung eines optoelektronischen Moduls (112) nach einem der vorhergehenden, ein optoelektronisches Modul (112) betreffenden Ansprüche, wobei das Linsensystem (122) derart hergestellt wird, insbesondere unter Verwendung eines Gießverfahrens, dass mindestens ein verformbarer Ausgangswerkstoff des Linsensystems (122) mit den optoelektronischen Komponenten (118) in Kontakt gebracht, geformt und ausgehärtet wird.

14. Verwendung eines optoelektronischen Moduls (112) nach einem der vorhergehenden, ein optoelektronisches Modul (112) betreffenden Ansprüche für eine Belichtungsanwendung und/oder für eine Bestrahlungsanwendung, wobei mindestens ein Werkstück mit von dem optoelektronischen Modul (112) emittierten elektromagnetischen Strahlen bestrahlt wird.

## Claims

1. An optoelectronic module (112), embodied as optoelectronic chip-on-board module (114), wherein the optoelectronic module (112) comprises a support (116), wherein the support (116) has a planar design, furthermore comprising a plurality of optoelectronic components (118) arranged on the support (116), wherein the optoelectronic module (112) furthermore comprises a lens system (122) comprising a plurality of lenses (124), wherein the optoelectronic components (118) are arranged in a two-dimensional array on the support (116);
the lens system (122) has at least two lenses (124) comprising different directional characteristics;
**characterised in that**
the at least two lenses (124) comprising a different directional characteristic comprise a different height;
wherein the lens system (122) has a gradual change of directional characteristics;
wherein the directional characteristics change continuously or discontinuously from an interior of the lens system (122) to an edge of the lens system (122); wherein at least one lens (124) of the lens system (122) has a surface curvature comprising at least one convexly curved region and at least one concavely curved region;
wherein the convexly curved and concavely curved regions are arranged on the side of the lens system (122) facing away from the support (116).

2. The optoelectronic module (112) according to the preceding claim, wherein the optoelectronic components (118) are arranged in a two-dimensional matrix.

3. The optoelectronic module (112) according to any one of the preceding claims, wherein the optoelectronic components (118) are selected from the group consisting of light-emitting diodes (120), in particular surface-emitting light-emitting diodes, and photodiodes.

4. The optoelectronic module (112) according to any one of the preceding claims, wherein the at least two lenses (124) comprising different directional characteristic comprise lenses (124) comprising different surface curvature.

5. The optoelectronic module (112) according to any one of the preceding claims, wherein the at least two lenses (124) comprising different directional characteristic comprise lenses (124) comprising different base.

6. The optoelectronic module (112) according to any one of the preceding claims, wherein the at least two lenses (124) comprising different directional chrematistic comprise lenses (124), in the case of which a respective optical axis of the lens (124) is oriented in a different manner to a respective optical axis of the optoelectronic component (118).

7. The optoelectronic module (112) according to any one of the preceding claims, wherein the lens system (122) comprises at least one lens (124), in the case of which an optical axis (134) of the lens (124) is arranged offset to an optical axis (132) of an optoelectronic component (118), which is assigned to the lens (124).

8. The optoelectronic module (112) according to any one of the preceding claims, wherein the lens system (122) is embodied such that exactly one lens (124) is assigned to each optoelectronic component (118).

9. The optoelectronic module (112) according to any one of the preceding claims, wherein at least one lens (124) is provided on an edge of the lens system (122), wherein the lens (124) has a smaller opening angle of the directional characteristic than at least one lens (124), which is arranged in an interior of the lens system (122).

10. The optoelectronic module (112) according to any one of the preceding claims, wherein at least one lens (124) is provided on an edge of the lens system (122), wherein the lens (124) has a larger opening angle of the directional characteristic than at least one lens (124), which is arranged in an interior of the lens system (122).

11. The optoelectronic module (112) according to any one of the preceding claims, wherein the concavely curved region is annularly surrounded by the convexly curved region.

12. An optoelectronic device (110) comprising at least two optoelectronic modules (112) according to any one of the preceding claims, wherein the supports (116) of the optoelectronic modules (112) are arranged adjacent to one another in the optoelectronic device (110).

13. A method for producing an optoelectronic module (112) according to any one of the preceding claims relating to an optoelectronic module (112), wherein the lens system (122) is produced such, in particular using a casting method, that at least one deformable starting material of the lens system (122) is brought into contact, formed and cured with the optoelectronic components (118).

14. A use of an optoelectronic module (112) according to any one of the preceding claims relating to an optoelectronic module (112), for a lighting application and/or for an irradiation application, wherein at least one workpiece is irradiated with electromagnetic rays emitted by the optoelectronic module (112).

## Revendications

1. Module optoélectronique (112), conçu comme module chip-on-board optoélectronique (114), le module optoélectronique (112) comprenant un support (116),
le support (116) étant conçu en surface, comprenant en outre une majorité de composants optoélectroniques (118) disposés sur le support (116), le module optoélectronique (112) comprenant en outre un système de lentilles (122) avec une majorité de lentilles (124),
les composants optoélectroniques (118) étant disposés dans une matrice bidimensionnelle sur le support (116) ;
le système de lentilles (122) présentant au moins deux lentilles (124) avec des caractéristiques directionnelles différentes ;
**caractérisé en ce que**
au moins les deux lentilles (124) avec des caractéristiques directionnelles différentes comprennent des lentilles (124) avec des hauteurs différentes ;
le système de lentilles (122) présentant un changement graduel des caractéristiques directionnelles ;
les caractéristiques directionnelles changeant de façon continue ou discontinue depuis un intérieur du système de lentilles (122) vers un bord du système de lentilles (122) ;
au moins une lentille (124) du système de lentilles (122) présentant une courbure de surface avec au moins une zone à courbure convexe et au moins une zone à courbure concave ;
les zones à courbure convexe et à courbure concave étant disposées sur une face du système de lentilles (122) tournée vers le support (116).

2. Module optoélectronique (112) conformément à la revendication précédente, les composants optoélectroniques (118) étant disposés dans une matrice bidimensionnelle.

3. Module optoélectronique (112) conformément à l'une des revendications précédentes, les composants optoélectroniques (118) étant sélectionnés à partir du groupe composé de diodes luminescentes (120), en particulier de diodes luminescentes à émission de surface, et de photodiodes.

4. Module optoélectronique (112) conformément à l'une des revendications précédentes, au moins les deux lentilles (124) avec des caractéristiques directionnelles différentes comprenant des lentilles (124) avec des courbures de surface différentes.

5. Module optoélectronique (112) conformément à l'une des revendications précédentes, au moins les deux lentilles (124) avec des caractéristiques directionnelles différentes comprenant des lentilles (124) avec des surfaces de base différentes

6. Module optoélectronique (112) conformément à l'une des revendications précédentes, au moins les deux lentilles (124) avec des caractéristiques directionnelles différentes comprenant des lentilles (124) pour lesquelles respectivement un axe optique de la lentille (124) est aligné différemment à un axe optique du composant optoélectronique (118).

7. Module optoélectronique (112) conformément à l'une des revendications précédentes, le système de lentilles (122) comprenant au moins une lentille (124) pour laquelle un axe optique (134) de la lentille (124) est disposé en décalage par rapport à un axe optique (132) d'un composant optoélectronique (118) affecté à la lentille (124).

8. Module optoélectronique (112) conformément à l'une des revendications précédentes, le système de lentilles (122) étant conçu de telle manière à ce qu'une lentille (124) soit précisément affectée à chaque composant optoélectronique (118).

9. Module optoélectronique (112) conformément à l'une des revendications précédentes, au moins une lentille (124) étant prévue sur un bord du système de lentilles (122), la lentille (124) présentant un plus petit angle d'ouverture de la caractéristique directionnelle qu'au moins une lentille (124) disposée dans un intérieur du système de lentilles (122).

10. Module optoélectronique (112) conformément à l'une des revendications précédentes, au moins une lentille (124) étant prévue sur un bord du système de lentilles (122), la lentille (124) présentant un plus grand angle d'ouverture de la caractéristique directionnelle qu'au moins une lentille (124) disposée dans un intérieur du système de lentilles (122).

11. Module optoélectronique (112) conformément à l'une des revendications précédentes, la zone à courbure concave étant entourée circulairement de la zone à courbure convexe.

12. Dispositif optoélectronique (110) comprenant au moins deux modules optoélectroniques (112) conformément à l'une des revendications précédentes, les supports (116) des modules optoélectroniques (112) étant disposés de manière adjacente l'un par rapport à l'autre dans le dispositif optoélectronique (110).

13. Procédé pour la fabrication d'un module optoélectronique (112) conformément à l'une des revendications précédentes, concernant un module optoélectronique (112), le système de lentilles (122) étant fabriqué, en particulier en utilisant un procédé de moulage, de manière à ce qu'au moins un matériau de départ déformable du système de lentilles (122) soit mis en contact avec les composants optoélectroniques (118), formé et durci.

14. Utilisation d'un module optoélectronique (112) conformément à l'une des revendications précédentes, concernant un module optoélectronique (112), pour une application d'exposition et/ou pour une application d'irradiation, au moins une pièce à usiner étant irradiée avec le rayonnement électromagnétique émis par le module optoélectronique (122).
